# EUROPÄISCHE PATENTSCHRIFT

(11) **EP 1 159 807 B1**
(45) Veröffentlichungstag und Bekanntmachung des Hinweises auf die Patenterteilung: **05.03.2008**
(21) Anmeldenummer: 00920367.0
(22) Anmeldetag: 01.03.2000
(51) Int. Cl.: H04L 25/02, H04L 7/10, H04J 3/06

(54) **GEWINNUNG VON TAKTSIGNALEN ZUR ABTASTUNG VON DATENSIGNALEN UNTERSCHIEDLICHER DATENRATEN MIT HILFE EINES PHASENREGELKREISES**
PRODUCTION OF CLOCK SIGNALS FOR SAMPLING DATA SIGNALS WITH DIFFERENT RATES USING A PHASE-LOCKING LOOP
PROCEDE ET DISPOSITIF D'OBTENTION AUTOMATIQUE DE SIGNAUX D'HORLOGE POUR L'ECHANTILLONNAGE DE SIGNAUX DE DONNEES A DES DEBITS DE DONNEES DIFFERENTS A L'AIDE D'UNE BOUCLE A PHASE ASSERVIE

(30) Priorität: 15.03.1999 DE 19911464
(43) Veröffentlichungstag der Anmeldung: 05.12.2001
(73) Patentinhaber: Nokia Siemens Networks GmbH & Co. KG, 81541 München (DE)
(72) Erfinder: DAUTH, Fritz, Jörg, D-83607 Holzkirchen (DE)
(86) Internationale Anmeldenummer: PCT/DE2000/000641
(87) Internationale Veröffentlichungsnummer: WO 2000/056026

(56) Entgegenhaltungen:
- EP-A- 0 862 272
- WO-A-97/37451
- WO-A-99/39483
- US-A- 5 297 181
- US-A- 5 541 933
- US-A- 5 572 515
- ANONYMOUS: "Dynamic Automatic Optical Baud Rate Selection" IBM TECHNICAL DISCLOSURE BULLETIN, Bd. 36, Nr. 5, 1. Mai 1993 (1993-05-01), Seiten 75-78, XP000885351 New York, US
- USHIROZAWA M ET AL: "Bit-rate-independent SDH/SONET regenerator for optical network" IEE CONFERENCE PUBLICATION,UK,LONDON: IEE, Bd. NO. 448, 22. September 1997 (1997-09-22), Seiten 25-28-28vol4, XP002106977 ISBN: 0-85296-697-0
- SCHEYTT J C ET AL: "A 0.155, 0.622, and 2.488 Gb/s automatic bit rate selecting clock and data recovery IC for bit rate transparent SDH-systems" 1999 IEEE INTERNATIONAL SOLID-STATE CIRCUITS CONFERENCE. DIGEST OF TECHNICAL PAPERS. ISSCC. FIRST EDITION (CAT. NO.99CH36278), 1999 IEEE INTERNATIONAL SOLID-STATE CIRCUITS CONFERENCE. DIGEST OF TECHNICAL PAPERS. ISSCC. FIRST EDITION, SAN FRANCISCO, C, Seiten 348-349, XP002143895 1999, Piscataway, NJ, USA, IEEE, USA ISBN: 0-7803-5126-6

## Beschreibung

Die weitgehende Transparenz optischer Netze hinsichtlich Datenübertragungsraten sowie der Einsatz unterschiedlicher Übertragungsverfahren bzw. Übertragungsprotokolle für die Übermittlung der digitalen Informationen - beispielsweise Synchrone Digitale Hierarchie SDH, Gigabit-Ethernet, Fiber Channel - erfordert zukünftige Einrichtungen zur Datenregenerierung bzw. zur Wiederherstellung der Amplitude, Flanke und des Taktes eins übermittelten, digitalen Datensignals bzw. Datenstromes - auch als "3R-Datenregenerierung" bezeichnet.

Vorrichtungen zur Erzeugung eines Taktsignals aus einem digitalen Datenstrom bzw. aus einem Datensignalstrom sind bekannt. Für die Taktrückgewinnung werden häufig Phasen/Frequenzregelkreise bzw. Phasenregelschleifen eingesetzt, welche beispielsweise einen Phasendiskriminator, einen Frequenzdiskriminator, Schleifenfilter, spannungsgesteuerte Oszillatoren - auch als VCO bezeichnet - und einstellbare digitale Frequenzteiler umfassen. Die Funktion von Phasenregelschleifen zur Rückgewinnung des Taktes aus einem digitalen Datenstrom und die Abtastung des zu regenerierenden, digitalen Datenstromes mit Hilfe eines Abtast-Flip-Flops sind dem Fachmann hinreichend bekannt, so daß auf deren Funktionsweise nicht näher eingegangen wird.

Zur Voreinstellung der Phasenregelschleife werden unterschiedliche Verfahren zur Ermittlung der Datenübertragungsrate des digitalen Datenstromes eingesetzt. Alle insbesondere in Weitverkehrsnetzen bzw. WAN-Kommunikationsnetzen eingesetzten Verfahren beruhen auf einer mehr oder weniger exakten Ermittlung der statistisch verteilten Flankenwechsel des Datenstromes innerhalb eines definierten Beobachtungszeitraumes. Aus der Anzahl der erkannten Flankenwechsel können Rückschlüsse auf die aktuelle Datenübertragungsrate geschlossen werden. Diese Verfahren werden auch als Flankendichteanalysen bezeichnet. Für niedrige Übertragungsraten kommen neben der beschriebenen Flankendichteanalyse auch Periodendauermessungen einzelner Bits zum Einsatz.

In der Offenlegungsschrift DE 197 04 299 A1 ist beispielsweise eine Vorrichtung zur Gewinnung eines Taktsignals aus einem Datensignal sowie eine Bitratenerkennungseinrichtung zur Ermittlung der Bitrate des eingehenden Datensignals beschrieben. Die Vorrichtung umfaßt eine Phasen-/Frequenzregeleinrichtung sowie eine im Rückkopplungszweig der Phasen-/Frequenzregeleinrichtung angeordnete und mit Hilfe eines Datenwortes umschaltbares Frequenzteilereinrichtung. Die umschaltbare Frequenzteilereinrichtung ist mit der Bitratenerkennungseinrichtung verbunden, welcher der digitale Datenstrom und zumindest ein Referenzfrequenzsignal zuführbar sind. In Abhängigkeit des anliegenden Referenzfrequenzsignals und des herangeführten digitalen Datenstromes wird durch die Bitratenerkennungseinrichtung ein Bitraten-abhängiges Datenwort erzeugt, welches anschließend der in der Phasen-/Frequenzregeleinrichtung angeordneten Frequenzteilereinrichtung zugeführt wird. Die beschriebene Vorrichtung zur Gewinnung eines Taktsignals aus einem digitalen Datensignal bzw. Datenstrom hat den Nachteil, daß die Auflösung der Erkennungsschaltung stark begrenzt ist, d.h. Übertragungsraten des digitalen Datenstromes, die sich um weniger als den Faktor 4 unterscheiden, können durch diese nicht sicher differenziert werden. Ein weiterer Nachteil besteht in der Gefahr einer Fehlsynchronisierung auf Nebenlinien des Frequenzspektrums während der Übertragung spezieller Dateninhalte - beispielsweise bei der Übertragung von AIS-Informationen bei SDH-Signalen - Synchrone Digitale Hierarchie.

Desweiteren offenbart die US-A-5 541 933 eine Taktrückgewinnung in einem DDS Netzwerk, bei dem im Synchronisiervorgang das Datensignal mit unterschiedlichen Frequenzen abgetastet wird, bis die für jede Taktrate gleiche, DDS-SC spezifische Rahmenstruktur erkannt wird.

Der Erfindung liegt die Aufgabe zugrunde, die Gewinnung eines Taktsignals aus einem übermittelten, digitalen Datensignal während eines Synchronisierungsvorgangs und insbesondere die Synchronisierung des Taktsignals auf das eingehende digitale Datensignal zu verbessern. Die Aufgabe wird durch ein Verfahren und durch eine Anordnung ausgehend von einem Verfahren und einer Anordnung gemäß den Merkmalen des Oberbegriffs der Patentansprüche 1 und 5 durch deren kennzeichnende Merkmale gelöst.

Durch das erfindungsgemäße Verfahren wird eine automatische Gewinnung von Taktsignalen zur Abtastung von Datensignalen unterschiedlicher Datenraten mit Hilfe eines Phasenregelkreises realisiert. Der wesentliche Aspekt des erfindungsgemäßen Verfahrens besteht darin, daß bei einem Synchronisiervorgang das Datensignal nacheinander mit einem Taktsignal mit unterschiedlichen Frequenzen, die unterschiedlichen Ubertragungsprotokollen zugeordnet sind, abgetastet und auf das Vorhandensein einer dem ausgewählten Taktsignal zugeordneten Protokoll-Identifizierungsinformation hin überprüft wird, bis eine Protokoll-Identifizierungsinformation detektiert wird.

Der wesentliche Vorteil des erfindungsgemäßen Verfahrens besteht darin, daß durch die Verknüpfung von der Erfassung der Übertragungsrate des übermittelten, digitalen Datensignals und der Erfassung des auf der Frequenz des digitalen Datensignals bzw. des erzeugten Taktsignals abgestimmten Ubertragungsprotokolls eine Fehlsynchronisation des erzeugten Taktsignals auf Nebenlinien, Harmonische und Subharmonische der Übertragungsfrequenz bzw. der Übertragungsrate des Datensignals vermieden wird. Durch das erfindungsgemäße Verfahren können auch im Frequenzbereich benachbart angeordnete Übertragungsraten sicher unterschieden werden - z.B. Unterscheidung von "Gigabit-Ethernet" mit einer Übertragungsrate von 1,25 GBit/s und "Fiber Channel" mit einer Übertragungsrate von 1,064 GBit/s. Ein weiterer Vorteil des erfindungsgemäßen Verfahrens besteht darin, daß eine automatische Einstellung der Übertragungsrate zur "3R-Datenregenerierung" für rahmenorientierte Übertragungsverfahren sowie die automatische Erkennung des jeweiligen Übertragungsprotokolls ermöglicht wird. Durch das erfindungsgemäße Verfahren wird in zukünftigen, optischen Kommunikationsnetzen neben einer reinen Wellenlängenkonvertierung mittels flexibler "3R-Datenregenerierung" eine Analyse der jeweils übertragenen digitalen Datensignale bzw. Datenströme ermöglicht - beispielsweise für die Aufbereitung einer Statistik, für die Realisierung einer Netzplanung oder für eine volumenabhängige Abrechnung.

Weitere vorteilhafte Ausgestaltungen des erfindungsgemäßen Verfahrens sowie eine Anordnung zur automatischen Gewinnung von Taktsignalen sind den weiteren Ansprüchen zu entnehmen.

Im folgenden wird das erfindungsgemäße Verfahren anhand zweier Zeichnungen näher erläutert. Dabei zeigen:
- FIG 1: eine Schaltungsanordnung zur erfindungsgemäßen Gewinnung eines Taktsignals aus einem übermittelten, digitalen Datenstrom und
- FIG 2: eine beispielhafte, tabellarische Darstellung der für die Durchführung des erfindungsgemäßen Verfahrens erforderlichen und in einem Speicher der Schaltungsanordnung gespeicherten binären Informationen.

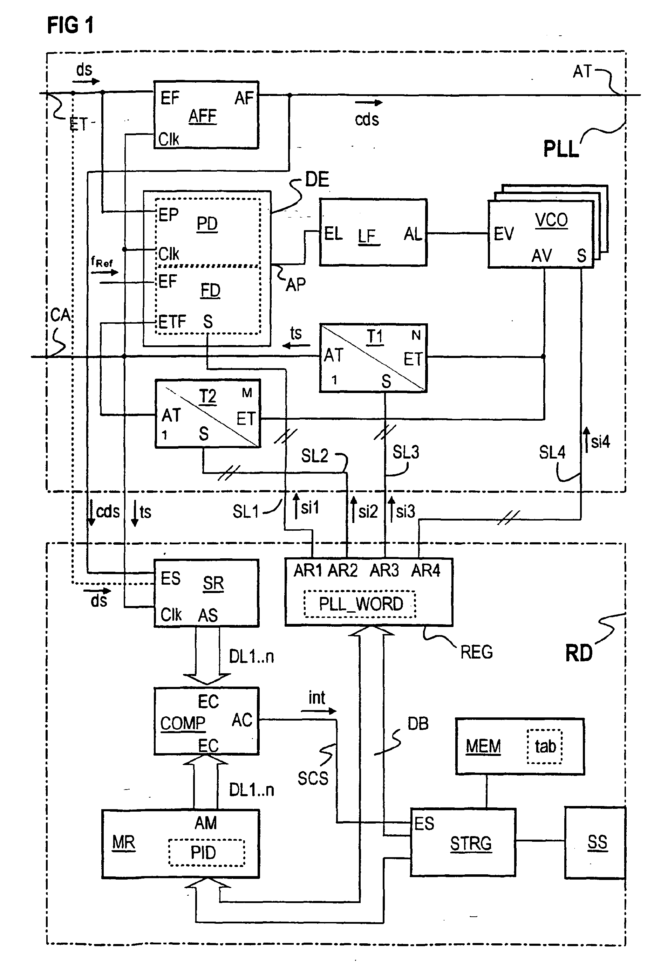

FIG 1 zeigt in einem Blockschaltbild ein Ausführungsbeispiel einer Schaltungsanordnung zur Erzeugung eines Taktsignals ts aus einem herangeführten, digitalen Datensignal bzw. Datenstrom ds. Die in FIG 1 dargestellte Schaltungsanordnung ist in zwei jeweils durch ein strichpunktiertes Rechteck dargestellte, funktionale Schaltungseinheiten PLL, RD unterteilbar. Die erste funktionale Schaltungseinheit umfaßt eine dem Fachmann allgemein bekannte Phasen-/Frequnezregeleinrichtung (PLL) - auch als Phasenregelkreis oder PLL-Schaltung bezeichnet - und die zweite Schaltungseinheit eine mit der Phasen-/Frequnezregeleinrichtung (PLL) verbundene Rahmenerkennungseinheit RD, welche im folgenden auch als Rahmendetektor bezeichnet wird.

An einem Eingang ET der Phasen-/Frequenzregeleinrichtung PLL ist ein mit Hilfe eines Übertragungsprotokolls übermittelter, digitaler Datenstrom ds herangeführt, welcher an einen Eingang EF eines Abtast-Flip-Flops AFF weitergeleitet ist. Für das Ausführungsbeispiel sei angenommen, daß der Datenstrom ds gemäß der Synchronen Digitalen Hierarchie - SDH - übermittelt werden. Die Synchrone Digitale Hierarchie basiert auf der synchronen Übertragung von Nutzinformationen unter Verwendung von synchronen Transportmodulen - auch als STM bezeichnet - mit einheitlicher Struktur. Das Basistransportmodul ist der STM-1-Rahmen mit einer Datenübertragungsrate von 155 MBit/s. Jeder STM-1-Rahmen besteht aus einer Matrix aus 9 Reihen mit jeweils 270 Datenoktetts. Der Rahmen hat eine Wiederholfrequnez von 125 µs, die Übertragung erfolgt mit einer Bitrate von 155,520 MBit/s. Der STM-1-Rahmen ist in ein Nutzfeld - auch als Payload bezeichnet - und ein Kopffeld - auch als Overhead bezeichnet -, die ersten 9 Oktett aller 9 Reihen beinhalten das Kopffeld, die restlichen Spalten das Nutzfeld. Im Kopffeld sind Informationen enthalten, die zum Betrieb der SDH-Systeme erforderlich sind, diese werden auch als "Section-Overhead" - SOH - bezeichnet und in den SOH-Feldern der Kopffeldes transportiert. In den SOH-Feldern sind beispielsweise die dem Fachmann bekannten und jeweils Rahmenerkennungs-Informationen repräsentierende A1- und A2-Bytes enthalten.

Der Dateneingang ET der Phasen-/Frequenzregeleinrichtung PLL ist gleichzeitig mit einem ersten Eingang EP einer Diskriminatoreinheit DE verbunden. An einen zweiten Eingang EF der Diskriminatoreinheit DE ist ein eine Referenzfrequenz aufweisendes Referenzsignal f_{Ref} herangeführt. Die Diskriminatoreinheit DE ist funktional in zwei Komponenten unterteilt, einem Phasendiskriminator PD und einem Frequenzfensterdiskriminator FD - jeweils durch ein strichliertes Rechteck verdeutlicht.

Die Diskriminatoreinheit DE ist über einen Ausgang AP mit einem Eingang EL eines Schleifenfilters LF verbunden, welcher wiederum über einen Ausgang AL mit einem Eingang EV-eines spannungsgesteuerten Oszillators VCO verbunden ist. An einen Ausgang AV des spannungsgesteuerten Oszillators VCO ist jeweils über einen Eingang ET ein erster und zweiter einstellbarer, digitaler Frequenzteiler T1, T2 angeschlossen. Über jeweils einen Ausgang AT sind der erste digitale Frequenzteiler T1 mit einem Takteingang CLK des Phasendiskriminators PD und der zweite digitale Frequenzteiler T2 mit einem Teilereingang ETF des Frequenzfensterdiskriminators FD verbunden. Die beschriebene Diskriminatoreinheit DE, bestehend aus einem Phasen- und einem Frequenzfensterdiskriminator PD, FD, sowie der Schleifenfilter LF, der spannungsgesteuerte Oszillator VCO und die beiden einstellbaren, digitalen Frequenzteiler T1, T2 sind funktionale Bestandteile einer allgemein bekannten Phasenregelschleife, deren Funktion zur Rückgewinnung des Taktes aus dem herangeführten Datenstrom ds neben der Abtaktung des zu regenerierenden Datenstromes ds in Verbindung mit dem Abtast-Flip-Flop AFF dem Fachmann hinreichend bekannt ist und im folgenden nicht näher beschrieben wird.

Die Phasen-/Frequnezregeleinrichtung PLL weist einen Taktausgang CA auf, welcher mit dem Ausgang AT des ersten Frequenzteilers T1 verbunden und an welchen das erzeugte Taktsignal ts weitergeleitet ist. Der Ausgang AT des ersten Frequenzteilers T1 ist weiterhin mit einem Takteingang CLK des Abtast-Flip-Flops AFF verbunden. Über einen Ausgang AF ist der Abtast-Flip-Flop AFF an einen Datenausgang AT der Phasen-/Frequnezregeleinrichtung PLL angeschlossen, an welchen der mit Hilfe des Abtast-Flip-Flops AFF regenerierte Datenstrom cds weitergeleitet ist. Desweiteren ist der Ausgang AF des Abtast-Flip-Flops AFF mit einem Eingang ES eines in der Rahmenerkennungseinheit RD angeordneten Schieberegisters SR verbunden. Das Schieberegister SR weist einen Takteingang CLK auf, welcher mit dem Ausgang AT des ersten Frequenzteiler T1 verbunden ist.

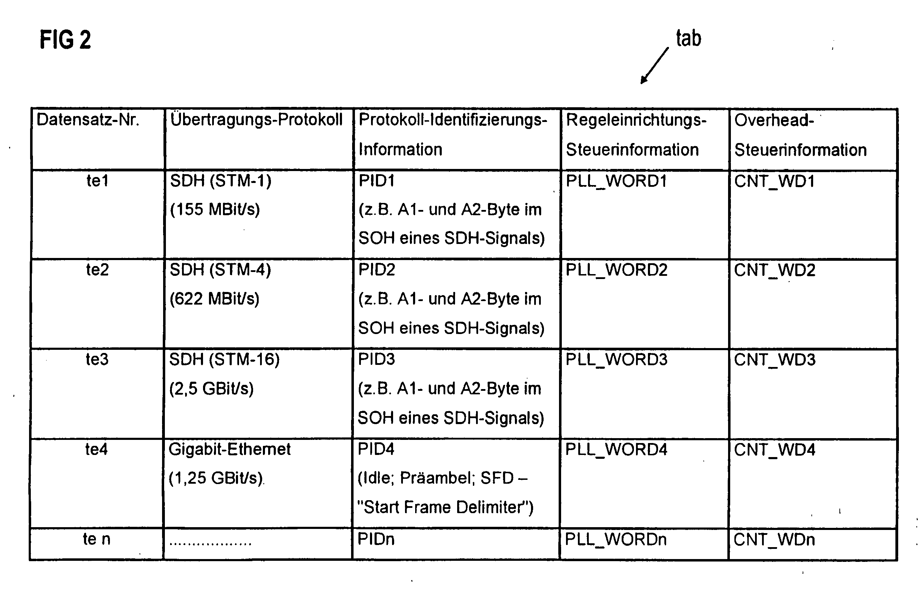

In der Rahmenerkennungseinheit RD ist weiterhin ein Speicher MEM angeordnet, welcher über eine Verbindungsleitung mit einer in der Rahmenerkennungseinheit RD angeordneten Steuereinheit STRG verbunden ist. Im Speicher MEM ist eine in FIG 2 dargestellte Tabelle tab gespeichert ist. Die dargestellte Tabelle tab umfaßt mehrere Tabelleneinträge tel...n, wobei jeder Tabelleneintrag tel...n jeweils einem definierten Übertragungsprotokoll zugeordnet ist. In jedem Tabelleneintrag tel...n ist eine das jeweils definierte Übertragungsprotokoll eindeutig identifizierende Protokoll-Identifizierungsinformation PID1...n - z.B. die in den Overhead-Informationen enthaltenen Rahmen-Erkennungsinformationen, hier das A1- und A2-Byte -, eine Regelkreis-Steuerinformation PLL_WORD1...n zur Einstellung der Phasen-/Frequenzregeleinrichtung PLL auf die zu erwartende Übertragungsrate des Datenstromes ds sowie eine weitere Overhead-Steuerinformation CNT_WD1...n zur optionalen protokollspezifischen Auswertung und Bearbeitung der in den jeweiligen Datenpakten bzw. Datenrahmen des Datenstromes ds, cds angeordneten Overhead-Informationen gespeichert. Mit Hilfe der Overhead-Steuerinformationen CNT_MD1...n können beispielsweise bei einem gemäß dem SDH-Übertragungsverfahren übermittelten Datenstrom ds das in den Overhead-Informationen enthaltene B1-Byte ausgewertet und eventuell neu berechnet werden.

Die Steuereinheit STRG ist über einen mehrere Datenleitungen umfassenden Datenbus DB mit einem in der Rahmenerkennungseinheit RD angeordneten Speicherregister MR verbunden, an welchem jeweils eine im Speicher MEM gespeicherte Protokoll-Identifizierungsinformation PID1...n übermittelbar und in diesem speicherbar ist - durch ein strichliertes Rechteck angedeutet. Das Schieberegister SR und das Speicherregister MR sind jeweils über einen Ausgang AS,AM und jeweils über mehrere Datenleitungen DL1...n mit entsprechenden Eingängen EC einer Vergleichereinheit COMP - beispielsweise einen Komparator - verbunden. In dem Komparator COMP sind Vergleichermittel angeordnet, durch welche die an den Eingängen EC anliegenden binären Informationen bzw. Datenworte verglichen werden und das Vergleichsergebnis in Form eines Datensignals int über einen Ausgang AC und eine Signalisierungsleitung SCS an einen Eingang ES der Steuereinheit STRG übermittelt wird.

Über den Datenbus DB ist die Steuereinheit STRG weiterhin mit einer Registereinheit REG verbunden, welche über erste Ausgänge A1 und über erste Steuerleitungen SL1 mit einem Steuereingang S des Frequenzfensterdiskriminators FD, über zweite Ausgänge A2 und über zweite Steuerleitungen SL2 mit entsprechenden Steuereingängen S des zweiten steuerbaren Frequenzteilers T2, über dritte Ausgänge A3 und dritte Steuerleitungen SL3 mit entsprechenden Eingängen S des ersten steuerbaren Frequenzteilers T1 und über vierte Ausgänge A4 und vierte Steuerleitungen SL4 mit entsprechenden Eingängen S des spannungsgesteuerten Oszillators VCO verbunden ist. Die Registereinheit REG weist ein oder mehrere Speicherregister auf - in FIG 1 ist nur ein Speicherregister durch ein strichliertes Rechteck dargestellt - in denen jeweils die im Speicher MEM gespeicherten Regeleinrichtungs-Steuerinformationen PLL_WORD1...n oder davon abgeleitete Steuerworte bzw. binäre Informationen speicherbar sind, mit denen die in der Phasen-/Frequnezregeleinrichtung PLL angeordneten schaltungstechnischen Komponenten - hier FD, PD, LF, VCO, T1 und T2 - gesteuert werden. Alternativ können von den in der Registereinheit REG gespeicherten Steuerworten analoge Signale abgeleitet und den schaltungstechnischen Komponenten zugeführt werden.

Die Rahmenerkennungseinheit RD weist weiterhin eine Steuer-/Überwachungsschnittstelle SS auf, welche über eine Verbindungsleitung mit der Steuereinheit STRG verbunden ist.

Das mit Hilfe der in FIG 1 dargestellten Schaltungsanordnung realisierbare Verfahren zur Erzeugung eines Taktsignals ts aus dem mit Hilfe eines Übertragungsprotokolls übermittelten digitalen Datenstrom ds ermöglicht wahlweise sowohl die manuelle als auch die automatische Auswahl eines Übertragungsprotokolls und eine entsprechende Voreinstellung einer an das ausgewählte Übertragungsprotokoll angepaßten Datenübertragungsrate. Im Folgenden wird das Verfahren zur Erzeugung des Taktsignals ts basierend auf einer manuellen - auch als manueller Betriebsmodus bezeichnet - und basierend auf einer automatischen Auswahl - auch als automatischer Betriebsmodus bezeichnet - des Übertragungsprotokolls und der dazugehörigen Datenübertragungsrate anhand der in FIG 1 dargestellten Schaltungsanordnung näher erläutert. Für das weitere Ausführungsbeispiel sei angenommen, daß der digitale Datenstrom ds mit Hilfe eines rahmenorientierten Übertragungsprotokolls - hier STM-1 - an den Eingang ET der Phasen-/Frequenzregeleinrichtung (PLL) übermittelt und an den Dateneingang EF des Abtast-Flip-Flops AFF weitergeleitet wird.

### Manueller Betriebsmodus

Bei manuellem Betrieb der Schaltungsanordnung ist das Übertragungsprotokoll bekannt, mit welchem der digitale Datenstrom ds an den Dateneingang EF des Abtast-Flip-Flops AFF übermittelt wird. Aufgrund der Kenntnis des Übertragungsprotokolls wird von der in der Rahmenerkennungseinheit RD angeordneten Steuereinheit STRG der dem STM-1-Übertragungsprotokoll zugeordnete erste Tabelleneintrag te1 der Tabelle tab ausgewählt und die entsprechende Regelkreis-Steuerinformation - hier PLL_Nort1 aus dem Speicher MEM ausgelesen und über den Datenbus DB in das oder die entsprechenden Register in der Registereinheit REG übermittelt. Alternativ können von der übermittelten Regelkreis-Steuerinformation PLL_Wort1 weitere Steuerinformationen abgleitet und in entsprechenden Register der Registereinheit REG gespeichert werden. Gemäß einer weiteren Ausgestaltungsvariante - nicht dargestellt - können auch mehrere dem STM-1-Übertragungsprotokoll zugeordnete Steuerworte bzw. Regeleinrichtungs-Steuerinformationen in den jeweiligen Tabelleneinträgen tel...n der Tabelle tab gespeichert sein - in FIG 2 nicht dargestellt -, welche über den Datenbus DB in entsprechende Register der Registereinheit REG übermittelt werden. Durch das Übermitteln des oder der im Speicher MEM gespeicherten Regelkreis-Steuerinformation PLL_Wort1...n werden die schaltungstechnischen Komponenten VCO, T1, T2, FD, PD, LF auf die entsprechende Datenübertragungsrate des eingehenden, digitalen Datenstromes ds - hier 155 MBit/s voreingestellt. Desweiteren wird durch die Steuereinheit STRG die dem ausgewählten Übertragungsprotokoll - hier STM-1 - zugeordnete Protokoll-Identifizierungsinformation - hier PID1 - aus dem entsprechenden Tabelleneintrag tel der Tabelle tab ausgelesen und über den Datenbus DB an das Speicherregister MR übermittelt und in diesem zwischengespeichert. In diesem Ausführungsbeispiel wird als Protokoll-Identifizierungsinformation PID1 das für das STM-1-Übertragungsprotokoll spezifische Rahmenkennungswort bestehend aus dem letzten A1-Byte und dem ersten A2-Byte der Overhead-Informationen an das Speicherregister REG übermittelt.

Wie bereits erläutert, wird die in der Phasen-/Frequenzregeleinrichtung PLL angeordnete Phasenregelschleife durch die in der Registereinheit REG gespeicherte Regelkreis-Steuerinformation PLL_WORD1 auf die Datenübertragungsrate des eingehenden digitalen Datenstromes ds angepaßt. Beispielsweise wird durch das Übermitteln entsprechender Steuerinformationen si2,3 über die Steuerleitungen SL2 und SL3 die steuerbaren Frequenzteiler T1, T2 derart eingestellt, daß die Frequenz des vom spannungsgesteuerten Oszillator VCO herangeführten Signals zur Anpassung des optimalen Arbeitspunktes des Phasen-Diskriminators PD und des Frequenzfenster-Diskriminators FD entsprechend geteilt wird. Mit Hilfe einer zusätzlichen über die vierte Steuerleitung SL4 übermittelten Steuerinformation - hier si4 - wird eine eventuelle erforderliche Voreinstellung bzw. Umschaltung des spannungsgesteuerten Oszillators VCO realisiert. Gemäß einer alternativen Ausgestaltungsvariante der Schaltungsanordnung können mehrere spannungsgesteuerte Oszillatoren VCO in der Phasen/Frequenzregeleinrichtung PLL angeordnet sein, wobei jeweils ein auf die Datenübertragungsrate des eingehenden digitalen Datenstroms ds abgestimmter spannungsgesteuerter Oszillator VCO mit Hilfe des vierten Steuersignals si4 selektierbar ist.

Gemäß einer weiteren, in FIG 1 nicht dargestellten Ausgestaltungsvariante der Schaltungsanordnung wird der in der Phasen-/Frequenzregeleinrichtung PLL angeordnete Schleifenfilter LF ebenfalls in Abhängigkeit der in der Registereinheit REG gespeicherten Regelkreis-Steuerinformation PLL_WORD1...n gesteuert.

Der mit Hilfe des rückgewonnenen Taktsignals ts abgetastete digitale Datenstrom cds wird in das Schieberegister SR eingelesen, d.h. das Schieberegister SR enthält die mit Hilfe des rückgewonnenen Taktes ts eingelesenen Datenbits. Alternativ kann auch der am Eingang ET anliegende, nicht abgetastete Datenstrom ds über eine Verbindungsleitung - in FIG 1 durch eine strichlierte Verbindungsleitung verdeutlicht - in das durch das Taktsignal ts getaktete Schieberegister SR eingelesen werden.

Die in das Schieberegister SR eingelesene Bitfolge wird durch die Vergleichereinheit COMP mit der im Speicherregister MR zwischengespeicherten Protokoll-Identifizierungsinformation - hier pid1 - permanent verglichen. Wird durch die Vergleichereinheit COMP eine Übereinstimmung bzw. teilweise Übereinstimmung der eingelesenen, digitalen Bitfolge mit der Protokoll-Identifizierungsinformation pid1 festgestellt, wird in der Vergleichereinheit COMP ein entsprechendes Steuersignal int generiert und über die Steuerleitung SCS an die Steuereinheit STRG übermittelt. Durch das Übermitteln der Steuerinformation int an die Steuereinheit STRG wird das Erkennen des ausgewählten Übertragungsprotokolls - hier STM1 - und die Einstellung der zugehörigen Datenübertragungsrate an der Phasen-/Frequenzregeleinrichtung PLL angezeigt.

Um eine Verbesserung der Synchronisierung des erzeugten Taktsignals ts mit dem eingehenden, digitalen Datenstrom ds zu erreichen, wird gemäß einer weiteren, nicht dargestellten Ausgestaltungsvariante durch die Steuereinheit STRG überprüft, ob die Protokoll-Identifizierungsinformation - hier pid1 - in einer für das ausgewählte Übertragungsprotokoll spezifischen Zykluszeit mehrfach, beispielsweise dreimal, erkannt wird. Liegt aufgrund des eingesetzten Ubertragungsprotokolls eine asynchrone Rahmenfolge vor - z.B. bei Verwendung des Gigabit-Ethernet-Übertragungsprotokolls - kann mit Hilfe dieser Ausgestaltungsvariante das Pausenpattern - auch als "Interframe Gap" bezeichnet - analysiert werden.

Mit Hilfe der Steuereinheit STRG kann bei Erkennen der ausgewählten bzw. erwarteten Protokoll-Identifizierungsinformation pid1 im abgetasteten Datenstrom cds der Beginn der Datenübertragung protokolliert werden. Vorteilhaft kann bei Ausbleiben der periodisch erzeugten Datenrahmen - z.B. bei Verwendung des STM-1-Übertragungsprotokolls - in Verbindung mit weiteren Parametern - z.B. Verlust des Signals (LOS, Lost of Signal) oder optische Pegel - auf eine Störung oder das Ende der Übertragung geschlossen werden. Durch die erfindungsgemäße Analyse der ankommenden Datenrahmen kann für den Fall, daß durch die in der Phasen-/Frequenzregeleinrichtung PLL angeordnete Phasenregelschleife eine Synchronisierung auf eine benachbarte Übertragungsrate - z.B. PDH mit 140 Mbit/s - erfolgt ist, die Nichtverwendung bzw. das Nichterkennen des vorgewählten Übertragungsprotokolls erkannt bzw. protokolliert werden. Wird z.B. das vorgewählte Übertragungsprotokoll nicht erkannt, kann ein automatischer Abbruch der Verbindung eingeleitet werden.

### Automatischer Betrieb

Bei Verwendung der in FIG 1 dargestellten Schaltungsanordnung im automatischen Betriebsmodus soll das durch die Phasen-/Frequenzregeleinrichtung PLL erzeugte Taktsignal ts ohne Bedienereingriff auf den am Dateneingang ET eingehenden digitalen Datenstrom aufsynchronisiert und eine anschließende "3D-Datenregenerierung" des digitalen Datenstromes ds ermöglicht werden. Dazu sind in der im Speicher MEM angeordneten Tabelle tab sämtliche zu erwartende Übertragungsprotokolle mit den dazugehörigen protokollspezifischen Protokoll-Identifizierungsinformationen pid1...n und zugehörige Regeleinrichtungs-Steuerinformation PLL_WORD1...n zur Einstellung der Phasen-/Frequenzregeleinrichtung PLL auf die zu erwartende Datenübertragungsrate gespeichert. Mit der Aktivierung des Automatik-Betriebsmodus wird die Steuereinheit STRG veranlaßt, die in der Tabelle tab des Speichers MEM angeordneten Protokoll-Identifizierungsinformationen PID1...n und Regeleinrichtungs-Steuerinformationen PLL_WORD1...n in beschriebener Art und Weise schrittweise so lange zyklisch an die Registereinheit REG bzw. an das Speicherregister MR zu übermitteln, bis durch die Vergleichereinheit COMP ein in der Tabelle tab gespeichertes, definiertes Übertragungsprotokoll erkannt und an die Steuereinheit STRG gemeldet wird. Bei Erkennen eines im Speicher MEM gespeicherten Übertragungsprotokolls wird das zyklische Abarbeiten der im Speicher MEM angeordneten Tabelle tab beendet. Bei Ausbleiben der Erkennung des aktuell selektierten Übertragungsprotokolls wird nach einer vordefinierten, protokollspezifischen Verzögerung das beschriebene, sukzessive Durchlaufen der gespeicherten Protokoll-Identifizierungsinformationen PID1...n, bzw. Regeleinrichtungs-Steuerinformationen PLL_NORD1...n erneut durchgeführt.

Der selbständige Ablauf der Protokollsuche kann vorteilhaft erst durch einen Bedienereingriff freigeschaltet werden. Gemäß einer weiteren vorteilhaften Ausgestaltung ist eine selektive Freischaltung von einer Auswahl der in der Tabelle tab gespeicherten Übertragungsprotokolle mit Hilfe einer entsprechenden Kennung in den jeweiligen Tabelleneinträgen te1...n möglich.

Zur weiteren Verbesserung der Synchronisierüberwachung kann der aktuelle Zustand Phasen-/Frequenzregeleinrichtung PLL mit Hilfe eines allgemein bekannten, zusätzlich in der Phasen-/Frequenzregeleinrichtung PLL angeordneten Lock-Detektors - nicht dargestellt - erfaßt und an die Steuereinheit STRG gemeldet werden.

Über die mit der Steuereinheit STRG verbundene Steuer-/Überwachungsschnittstelle SS können die im Speicher MEM gespeicherten Tabelleneinträge te1...n bearbeitet bzw. aktualisiert werden, sowie neben der Überwachung der jeweils übertragenen Übertragungsprotokolle die Freischaltung bestimmter Übertragungsprotokolle gesteuert werden. Über die Steuer/Überwachungschnittstelle SS kann weiterhin zwischen dem beschriebenen manuellen oder automatischen Betriebsmodus umgeschaltet werden. Die Steuer-/Überwachungsschnittstelle SS kann beispielsweise an eine übergeordnete Netzwerkverwaltungs- oder Netzwerkmanagementeinheit angeschlossen werden, so daß es beispielsweise einem Netzbetreiber ermöglicht wird, die Datenübertragungsrate des an der Phasen-/Frequenzregeleinrichtung PLL eingehenden digitalen Datenstromes ds zu überwachen und zu steuern.

Durch die erfindungsgemäße Verknüpfung der Voreinstellung der zu erwartenden Datenübertragungsrate an der dem Fachmann allgemein bekannten Phasen-/Frequenzregeleinrichtung PLL und der Überprüfung des für die Vermittlung des digitalen Datenstromes eingesetzten Übertragungsprotokolls durch eine teilweise Auswertung der in den einzelnen Datenrahmen enthaltenen Overhead-Informationen wird eine Fehlsynchronisierung des Taktsignals auf Nebenlinien, Harmonischen und Subharmonischen der Datenübertragungsrate vermieden. Durch das erfindungsgemäße Verfahren können auch nur einen geringen Abstand aufweisende Datenübertragungsraten durch Auswertung der unterschiedlichen Overhead-Informationen sicher unterschieden werden.

## Patentansprüche

1. Verfahren zur automatischen Gewinnung von Taktsignalen (ts) zur Abtastung von Datensignalen (ds) unterschiedlicher Datenraten mit Hilfe eines Phasenregelkreises (PLL),
**dadurch gekennzeichnet,**
**daß** bei einem Synchronisiervorgang das Datensignal (cds,ds) nacheinander mit einem Taktsignal (ts) mit unterschiedlichen Frequenzen, die unterschiedlichen Übertragungsprotokollen zugeordnet sind, abgetastet und auf das Vorhandensein einer dem ausgewählten Taktsignal (ts) zugeordneten Protokoll-Identifizierungsinformation (PID1...n) hin überprüft wird, bis eine Protokoll-Identifizierungsinformation (PID1...n) detektiert wird.

2. Verfahren nach Anspruch 1,
**dadurch gekennzeichnet,**
**daß** die Protokoll-Identifizierungsinformation (PID1...n) im Overhead eines Datenrahmens enthalten ist.

3. Verfahren nach Anspruch 1 oder 2,
**dadurch gekennzeichnet,**
**daß** die Protokoll-Identifizierungsinformation (PID1...n) ein Pausensignal repräsentiert.

4. Verfahren nach Anspruch 2 oder 3,
**dadurch gekennzeichnet,**
**daß** nach der Detektion des verwendeten Übertragungsprotokolls eine protokollspezifische Bearbeitung zumindest eines Teils der jeweiligen Overhead-Informationen erfolgt.

5. Anordnung zur automatischen Gewinnung von Taktsignalen (ts) zur Abtastung von mit Hilfe von Übertragungsprotokollen übermittelten Datensignalen (ds) unterschiedlicher Datenraten, wobei die Datensignale (ds) zumindest eine das Übertragungsprotokoll eindeutig identifizierende, binäre Protokoll-Identifizierungsinformation (PID1...n) aufweisen,
- mit einem Phasenregelkreis (PLL) zur Synchronisierung des Taktsignals (ts) mit dem an die Phasen-/Frequenzregeleinrichtung herangeführten digitalen Datensignal (ds),
- mit zumindest einer im Rückkopplungszweig der Phasen/Frequenzeinrichtung (PLL) angeordneten, steuerbaren Frequenzteilereinrichtung (T1,2),
- mit Abtastmitteln (AFF, SR) zur Abtastung des digitalen Datensignals (ds) mit Hilfe des Taktsignals (ts),
**dadurch gekennzeichnet,**
- **daß** eine Steuereinheit (STRG, REG) vorgesehen ist, die eine einem Übertragungsprotokoll entsprechende Frequenz des Taktsignals (ts) einstellt,
- **daß** ein Protokolldetektor (RD) vorgesehen ist, in welchem die Steuereinheit (STRG, REG) angeordnet ist und der zumindest einen Teil des abgetasteten Datensignals (cds, ds) speichert und auf Protokoll-Identifizierungsinformationen (PID1...n) hin untersucht und das Untersuchungsergebnis an die Steuereinheit (STRG) übermittelt, die bei einer fehlenden Protokoll-Identifizierungsinformation (PID1...n) weitere festgelegte Frequenzen des Taktsignals (ts) auswählt, bis eine Protokoll-Identifizierungsinformation (PID1...n) im abgetasteten Datensignal (cds, ds) erkannt wird.

6. Anordnung nach Anspruch 5,
**dadurch gekennzeichnet,**
- **daß** im Protokolldetektor (RD) mit der Steuereinheit (STRG, REG) verbundene Speichermittel (MEM) zum Abspeichern zumindest einer binären Protokoll-Identifizierungsinformation (PID1...n) und zumindest einer der Protokoll-Identifizierungsinformation (PID1...n) jeweils zugeordneten und den Phasenregelkreis (PLL) protokollspezifisch steuernden Regeleinrichtungs-Steuerinformation (PLL_WORD1...n) angeordnet sind,
- **daß** die Steuereinheit (STRG, REG) Mittel zur Bildung von zumindest einem Steuersignal (sil...4) aus der zumindest einen einer Protokoll-Identifizierungsinformation (PID1...n) zugeordneten Regeleinrichtungs-Steuerinformation (PLL_WORD1...n) aufweist, wobei das zumindest eine Steuersignal (sil...4) an den Phasenregelkreis (PLL) übermittelt wird,
- **daß** im Protokolldetektor (RD) mit der Steuereinheit (STRG, REG) verbundene Detektormittel (SR, COMP, MR) zur Detektion der gespeicherten und der zumindest einen Regeleinrichtungs-Steuerinformation (PLL_WORD1...n) zugeordneten Protokoll-Identifizierungsinformation (PID1...n) im abgetasteten Datensignal (cds, ds) angeordnet sind,
- **daß** die Detektormittel (SR, COMP, MR) Signalerzeugungsmittel zur Erzeugung eines das Detektionsergebnis repräsentierenden Steuersignals (int) aufweisen, das an die Steuereinheit (STRG, REG) übermittelt wird, und
- **daß** die Steuereinheit (STRG, REG) derart ausgestaltet ist, daß aus der zumindest einen gespeicherten Regeleinrichtungs-Steuerinformation (PLL_WORD1...n) zumindest ein eine Frequenzteiler-Steuerinformation repräsentierendes Steuersignal (sil,3) gebildet und an die zumindest eine Frequenzteilereinrichtung (T1,2) übermittelt wird.

7. Anordnung nach Anspruch 6,
**dadurch gekennzeichnet,**
**daß** die Steuereinheit (STRG, REG) derart ausgestaltet ist, daß bei mehreren in den Speichermitteln (MEM) gespeicherten Protokoll-Identifizierungsinformationen (pid1...n) die diesen zugeordneten Regeleinrichtungs-Steuerinformationen (PLL_WORD1...n) sukzessive an den Phasenregelkreis (PLL) übermittelt und die jeweils zugeordneten Protokoll-Identifizierungsinformationen (PID1...n) im abgetasteten Datenstrom (ds, cds) sukzessive detektiert werden, wobei die sukzessive Übermittlung der Regeleinrichtungs-Steuerinformationen (PLL_WORD1...n) in Abhängigkeit von dem Detektionsergebnisserfolgt.

8. Anordnung nach Anspruch 6 oder 7,
**dadurch gekennzeichnet,**
- **daß** die Detektormittel (SR, COMP, MR)
-- ein Schieberegister (SR), an welches das abgetastete Datensignal oder das Datensignal (cds, ds) und das Taktsignal (ts) herangeführt sind,
-- einen mit dem Schieberegister (SR) und mit der Steuereinheit (STRG, REG) verbundenen Komparator (COMP), und
-- ein mit dem Komparator (COMP) und der Steuereinheit (STRG) verbundenes Speicherregister (MR) zum Zwischenspeichern einer Protokoll-Identifizierungsinformation (PID1...n)
umfaßt,
- **daß** der Komparator (COMP) derart ausgestaltet ist, daß die im Speicherregister (MR) gespeicherte Protokoll-Identifizierungsinformation (PID1...n) mit dem in das Schieberegister (SR) eingelesenen, digitalen Datensignal (cds, ds) verglichen wird und das Vergleichsergebnis mit Hilfe des Steuersignals (int) an die Steuereinheit (STRG) übermittelt wird.

9. Anordnung nach einem der Ansprüche 6 bis 8,
**dadurch gekennzeichnet,**
- **daß** in den Speichermitteln (MEM) unterschiedliche Protokoll-Identifizierungsinformationen (PID1...n) und diesen zugeordnete Overhead-Steuerinformationen (CNT_WD1...n) gespeichert sind,
- **daß** das abgetastete Datensignal (cds, ds) einer mit der Steuereinheit (STRG, REG) verbunden Overhead-Bearbeitungseinheit zur Bearbeitung von im Datensignal (cds, ds) enthaltenen protokollspezifischen Overhead-Informationen zugeführt ist,
- **daß** die Overhead-Bearbeitungseinheit und die Steuereinheit (STRG, REG) derart ausgestaltet sind, daß die Overhead-Informationen in Abhängigkeit der zumindest einen dem detektierten Übertragungsprotokoll zugeordneten Overhead-Steuerinformation (CNT_WD1...n) bearbeitet werden.

10. Anordnung nach einem der Ansprüche 6 bis 9,
**dadurch gekennzeichnet,**
**daß** die Steuereinheit (STRG, REG) mit einer Steuer-/Überwachungsschnittstelle (SS) verbunden ist, über welche
- die in den Speichermitteln (MEM) gespeicherten Informationen (PID1...n, PLL_WORD1...n, CNT_WD1...n) aktualisierbar sind, und/oder
- Detektionsergebnisse an eine übergeordnete Kommunikationseinheit übermittelbar sind.

11. Anordnung nach einem der Ansprüche 6 bis 10,
**dadurch gekennzeichnet,**
**daß** mehrere spannungsgesteuerte Oszillatoren (VCO) in Abhängigkeit von der Regeleinrichtungs-Steuerinformation (PLL_WORD1...n) auswählbar sind.

12. Anordnung nach einem der Ansprüche 6 bis 11,
**dadurch gekennzeichnet,**
**daß** im Phasenregelkreis (PLL) ein Frequenzfenster-Diskriminator (FD) vorgesehen ist, der die Frequenz des Taktsignals (ts) in Abhängigkeit von der Regeleinrichtungs-Steuerinformation (PLL_WORD1...n) festlegt und der ebenfalls von der Steuereinheit (STRG, REG) eingestellt wird.

13. Anordnung nach einem der Ansprüche 5 bis 12,
**dadurch gekennzeichnet,**
**daß** im Phasenregelkreis (PLL) ein Schleifenfilter (LF) vorgesehen ist, der von der Steuereinheit (STRG) eingestellt wird.

14. Anordnung nach einem der Ansprüche 5 bis 13
**dadurch gekennzeichnet,**
**daß** das Übertragungsprotokoll ein STM-1- oder STM-4- oder STM-16-, ein Fiber-Channel- oder ein Gigabit-Ethernet-Protokoll darstellt.

15. Verfahren nach einem der Ansprüche 1 bis 4,
**dadurch gekennzeichnet,**
**dass** das Übertragungsprotokoll ein STM-1- oder STM-4- oder STM-16-, ein Fiber-Channel- oder ein Gigabit-Ethernet-Protokoll darstellt.

## Claims

1. Method for automatically producing clock signals (ts) for sampling data signals (ds) at different data rates by means of a phase locked loop (PLL),
**characterized**
**in that**, during a synchronization process, the data signal (cds, ds) is sampled successively using a clock signal (ts) at different frequencies, which are associated with different transmission protocols, and is checked for the presence of protocol identification information (PID1...n) associated with the selected clock signal (ts), until protocol identification information (PID1...n) is detected.

2. Method according to claim 1,
**characterized**
**in that** the protocol identification information (PID1...n) is included in the overhead of a data frame.

3. Method according to claim 1 or 2,
**characterized**
**in that** the protocol identification information (PID1...n) represents a pause signal.

4. Method according to claim 2 or 3,
**characterized**
**in that**, once the transmission protocol being used has been detected, protocol-specific processing of at least some of the respective overhead information is carried out.

5. Arrangement for automatically producing clock signals (ts) for sampling data signals (ds), which are transmitted with the aid of transmission protocols, at different data rates, with the data signals (ds) having at least one binary protocol identification information item (PID1...n) which uniquely identifies the transmission protocol,
- having a phase locked loop (PLL) for synchronization of the clock signal (ts) to the digital data signal (ds) passed to the phase/frequency control device,
- having at least one controllable frequency divider device (T1, T2) which is arranged in the feedback path of the phase/frequency device (PLL),
- having sampling means (AFF, SR) for sampling the digital data signal (ts) with the aid of the clock signal (ts),
**characterized**
- **in that** a control unit (STRG, REG) is provided, which sets the clock signal (ts) to a frequency which corresponds to a transmission protocol,
- **in that** a protocol detector (RD) is provided, in which the control unit (STRG, REG) is arranged and which stores at least a portion of the sampled data signal (cds, ds) and investigates it for protocol identification information (PID1...n) and transmits the investigation result to the control unit (STRG), which, if there is no protocol identification information (PID1...n), selects further defined frequencies for the clock signal (ts) until protocol identification information (PID1...n) is identified in the sampled data signal (cds, ds).

6. Arrangement according to claim 5,
**characterized**
- **in that** memory means (MEM), which are connected to the control unit (STRG, REG), are arranged in the protocol detector (RD) in order to store at least one binary protocol identification information item (PID1...n) and at least one control device control information item (PLL_WORD1...n) which is associated with the respective protocol identification information item (PID1...n) and controls the phase locked loop (PLL) on a protocol-specific basis,
- **in that** the control unit (STRG, REG) has means for forming at least one control signal (si1...4) from the at least one control device control information item (PLL_WORD1...n) which is associated with the protocol identification information item (PID1...n), with the at least one control signal (si1...4) being transmitted to the phase locked loop (PLL),
- **in that** detector means (SR, COMP, MR), which are connected to the control unit (SGRG, REG) are arranged in the protocol detector (RD) for detection of the stored protocol identification information (PID1...n) which is stored and is associated with the at least one control device control information item (PLL_WORD1...n) in the sampled data signal (cds, ds),
- **in that** the detector means (SR, COMP, MR) have signal production means for producing a control signal (int) which represents the detection result and is transmitted to the control unit (STRG, REG), and
- **in that** the control unit (STRG, REG) is designed such that at least one control signal (si1,3), which represents a frequency divider control information item, is formed from the at least one stored control device control information item (PLL_WORD1...n), and is transmitted to the at least one frequency divider device (T1, T2).

7. Arrangement according to claim 6,
**characterized**
**in that** the control unit (STRG, REG) is designed such that, if there are a number of protocol identification information items (pid1...n) stored in the memory means (MEM), the control device control information items (PLL_WORD1...n) associated with them are transmitted successively to the phase locked loop (PLL), and the respectively associated protocol identification information items (PID1...n) are detected successively in the sampled data stream (ds, cds), with the control device control information items (PLL_WORD1...n) being transmitted successively as a function of the detection result.

8. Arrangement according to claim 6 or 7,
**characterized**
- **in that** the detector means (SR, COMP, MR) have
-- a shift register (SR) to which the sampled data signal or the data signal (cds, ds) and the clock signal (ts) are passed,
-- a comparator (COMP) which is connected to the shift register (SR) and to the control unit (STRG, REG), and
-- a memory register (MR), which is connected to the comparator (COMP) and to the control unit (STRG) for temporary storage of protocol identification information (PID1...n), and
- **in that** the comparator (COMP) is designed such that the protocol identification information (PID1...n) stored in the memory register (MR) is compared with the digital data signal (cds, ds) read to the shift register (SR), and the comparison result is transmitted to the control unit (STRG) with the aid of the control signal (int).

9. Arrangement according to one of claims 6 to 8,
**characterized**
- **in that** different protocol identification information items (PID1...n) and overhead control information items (CNT_WD1...n) associated with them are stored in the memory means (MEM),
- **in that** the sampled data signal (cds, ds) is supplied to an overhead processing unit, which is connected to the control unit (STRG, REG), for processing protocol-specific overhead information included in the data signal (cds, ds), and
- **in that** the overhead processing unit and the control unit (STRG, REG) are designed such that the overhead information is processed as a function of the at least one overhead control information item (CNT_WD1...n) associated with the detected transmission protocol.

10. Arrangement according to one of claims 6 to 9,
**characterized**
**in that** the control unit (STRG, REG) is connected to a control/monitoring interface (SS), via which
- the information (PID1...n, PLL_WORD1...n, CNT_WD1...n) stored in the memory means (MEM) can be updated, and/or
- detection results can be transmitted to a higher-level communications unit.

11. Arrangement according to one of claims 6 to 10,
**characterized**
**in that** a number of voltage controlled oscillators (VCO) can be selected as a function of the control device control information (PLL_WORD1...n).

12. Arrangement according to one of claims 6 to 11,
**characterized**
**in that** a frequency window discriminator (FD) is provided in the phase locked loop (PLL), which defines the frequency of the clock signal (ts) as a function of the control device control information (PLL_WORD1...n) and is likewise set by the control unit (STRG, REG).

13. Arrangement according to one of claims 5 to 12,
**characterized**
**in that** a loop filter (LF) is provided in the phase locked loop (PLL), and is set by the control unit (STRG).

14. Arrangement according to one of claims 5 to 13,
**characterized**
**in that** the transmission protocol represents an STM-1, STM-4, STM-16, fiber channel or Gigabit-Ethernet protocol.

15. Method according to one of claims 1 to 4,
**characterized**
**in that** the transmission protocol represents an STM-1, STM-4, STM-16, fiber channel or Gigabit-Ethernet protocol

## Revendications

1. Procédé d'obtention automatique de signaux d'horloge (ts) pour l'échantillonnage de signaux de données (ds) à débits de données différents au moyen d'une boucle d'asservissement de phase (PLL),
**caractérisé en ce que**
lors d'une opération de synchronisation, le signal de données (cds, ds) est successivement échantillonné avec un signal d'horloge (ts) à des fréquences différentes attribuées à des protocoles de transmission différents et vérifié quant à la présence d'une information d'identification du protocole (PID1...n) attribuée au signal d'horloge (ts) sélectionné jusqu'à ce qu'une information d'identification du protocole (PID1...n) soit détectée.

2. Procédé selon la revendication 1,
**caractérisé en ce que**
l'information d'identification du protocole (PID1...n) est contenue dans l'overhead d'une trame de données.

3. Procédé selon la revendication 1 ou 2,
**caractérisé en ce que**
l'information d'identification du protocole (PID1...n) représente un signal de pause.

4. Procédé selon la revendication 2 ou 3,
**caractérisé en ce que**
après la détection du protocole de transmission utilisé, un traitement propre au protocole d'au moins une partie de l'information d'overhead respective est effectué.

5. Dispositif d'obtention automatique de signaux d'horloge (ts) pour l'échantillonnage de signaux de données (ds) à débits de données différents transmis au moyen de protocoles de transmission, lesdits signaux de données (ds) comportant au moins une information d'identification du protocole (PID1...n) binaire, identifiant clairement le protocole de transmission,
- comprenant une boucle d'asservissement de phase (PLL) pour synchroniser le signal d'horloge (ts) avec le signal de données numériques (ds) amené au dispositif d'asservissement de phase/fréquence,
- comprenant au moins un dispositif diviseur de fréquence (T1, 2) apte à être commandé, disposé dans la branche de rétroaction du dispositif d'asservissement de phase/fréquence (PLL),
- comprenant des moyens d'échantillonnage (AFF, SR) pour échantillonner le signal de données numériques (ds) au moyen du signal d'horloge (ts),
**caractérisé**
- **en ce qu'**une unité de commande (STRG, REG) est prévue, qui règle une fréquence du signal d'horloge (ts) correspondant à un protocole de transmission,
- **en ce qu'**un détecteur de protocole (RD) est prévu, dans lequel est agencée l'unité de commande (STRG, REG) et qui stocke au moins une partie du signal de données échantillonné (cds, ds) et la vérifie quant à la présence d'informations d'identification du protocole (PID1...n) et transmet le résultat de la vérification à l'unité de commande (STRG) qui en l'absence d'une information d'identification du protocole (PID1...n) sélectionne d'autres fréquences déterminées du signal d'horloge (ts) jusqu'à ce qu'une information d'identification du protocole (PID1...n) soit détectée dans le signal de données échantillonné (cds, ds).

6. Dispositif selon la revendication 5,
**caractérisé**
- **en ce que** des moyens de stockage (MEM) reliés à l'unité de commande (STRG, REG) sont agencés dans le détecteur de protocole (RD), pour stocker en mémoire au moins une information d'identification du protocole (PID1...n) binaire et au moins une information de commande du dispositif d'asservissement (PLL_WORD1...n) associée à l'information d'identification du protocole (PID1...n) et commandant la boucle d'asservissement de phase (PLL) en fonction du protocole,
- **en ce que** l'unité de commande (STRG, REG) comporte des moyens pour former au moins un signal de commande (si1...4) à partir de ladite au moins une information de commande du dispositif d'asservissement (PLL_WORD1...n) associée à une information d'identification du protocole (PID1...n), ledit au moins un signal de commande (si1...4) étant transmis à ladite boucle d'asservissement de phase (PLL),
- **en ce que** des moyens de détection (SR, COMP, MR) reliés à l'unité de commande (STRG, REG) sont agencés dans le détecteur de protocole (RD), pour détecter l'information d'identification du protocole (PID1...n), stockée et associée à ladite au moins une information de commande du dispositif d'asservissement (PLL_WORD1...n), dans le signal de données échantillonné (cds, ds),
- **en ce que** les moyens de détection (SR, COMP, MR) comportent des moyens de génération de signaux pour générer un signal de commande (int) représentant le résultat de la détection et qui est transmis à l'unité de commande (STRG, REG), et
- **en ce que** l'unité de commande (STRG, REG) est configurée de manière à former à partir de ladite au moins une information de commande du dispositif d'asservissement (PLL_WORD1...n) au moins un signal de commande (si1, 3) représentant une information de commande du diviseur de fréquence et à transmettre celui-ci audit au moins un dispositif diviseur de fréquence (T1, 2).

7. Dispositif selon la revendication 6,
**caractérisé en ce que**
l'unité de commande (STRG, REG) est configurée de manière qu'en présence de plusieurs informations d'identification du protocole (pid1...n) stockées dans les moyens de stockage (MEM), les informations de commande du dispositif d'asservissement (PLL_WORD1...n) associées à celles-ci soient successivement transmises à la boucle d'asservissement de phase (PLL) et les informations d'identification du protocole (PID1...n) à chaque fois associées soient successivement détectées dans le flux de données échantillonné (ds, cds), la transmission successive des informations de commande du dispositif d'asservissement (PLL_WORD1...n) s'effectuant en fonction du résultat de la détection.

8. Dispositif selon la revendication 6 ou 7,
**caractérisé**
- **en ce que** les moyens de détection (SR, COMP, MR) comprennent
-- un registre à décalage (SR) auquel le signal de données échantillonné ou le signal de données (cds, cd) et le signal d'horloge (ts) sont amenés,
-- un comparateur (COMP) relié au registre à décalage (SR) et à l'unité de commande (STRG, REG), et
-- un registre mémoire (MR) relié au comparateur (COMP) et à l'unité de commande (STRG, REG), pour le stockage intermédiaire d'une information d'identification du protocole (PID1...n),
- **en ce que** le comparateur (COMP) est configuré de manière que l'information d'identification du protocole (PID1...n) stockée dans le registre mémoire (MR) soit comparée avec le signal de données numériques (cds, ds) stocké dans le registre à décalage (SR) et le résultat de la comparaison soit transmis à l'unité de commande (STRG) au moyen du signal de commande (int).

9. Dispositif selon l'une des revendications 6 à 8,
**caractérisé**
- **en ce que** des informations d'identification du protocole (PID1...n) différentes et des informations de commande de l'overhead (CNT_WD1...n) associées à celles-ci sont stockées dans les moyens de stockage (MEM),
- **en ce que** le signal de commande échantillonné (cds, ds) est amené à une unité de traitement de l'overhead reliée à l'unité de commande (STRG, REG), pour le traitement d'informations d'overhead propres au protocole, contenues dans le signal de données (cds, ds),
- **en ce que** l'unité de traitement de l'overhead et l'unité de commande (STRG, REG) sont configurées de manière que les informations d'overhead soient traitées en fonction de ladite au moins une information de commande de l'overhead (CNT_WD1...n) associée au protocole de transmission détecté.

10. Dispositif selon l'une des revendications 6 à 9,
**caractérisé en ce que**
l'unité de commande (STRG, REG) est reliée à une interface de commande/surveillance (SS), par l'intermédiaire de laquelle
- les informations (PID1...n, PLL_WORD1...n, CNT_WD1...n) stockées dans les moyens de stockage (MEM) peuvent être actualisées et/ou
- les résultats de la détection peuvent être transmis à une unité de communication supérieure.

11. Dispositif selon l'une des revendications 6 à 10,
**caractérisé en ce que**
plusieurs oscillateurs commandés en tension (VCO) peuvent être sélectionnés en fonction de l'information de commande du dispositif d'asservissement (PLL_WORD1...n).

12. Dispositif selon l'une des revendications 6 à 11,
**caractérisé en ce que**
un discriminateur de fenêtre de fréquences (FD) est prévu dans la boucle d'asservissement de phase (PLL), qui détermine la fréquence du signal d'horloge (ts) en fonction de l'information de commande du dispositif d'asservissement (PLL_WORD1...n) et qui est également réglé par l'unité de commande (STRG, REG).

13. Dispositif selon l'une des revendications 5 à 12,
**caractérisé en ce que**
un filtre à boucle (LF) est prévu dans la boucle d'asservissement de phase (PLL), qui est réglé par l'unité de commande (STRG).

14. Dispositif selon l'une des revendications 5 à 13,
**caractérisé en ce que**
le protocole de transmission constitue un protocole STM-1 ou STM-4 ou STM-16, un protocole Fibre Channel ou un protocole Gigabit Ethernet.

15. Dispositif selon l'une des revendications 1 à 4,
**caractérisé en ce que**
le protocole de transmission constitue un protocole STM-1 ou STM-4 ou STM-16, un protocole Fibre Channel ou un protocole Gigabit Ethernet.
